# EUROPEAN PATENT APPLICATION

(11) **EP 1 933 603 A1**
(43) Date of publication of application: **18.06.2008**
(21) Application number: 06796442.9
(22) Date of filing: 15.08.2006
(51) Int. Cl.: H05B 33/26, H01B 5/14, H01L 51/50, H05B 33/28

(54) **CONDUCTIVE LAMINATE AND ORGANIC EL DEVICE**

(30) Priority: 12.09.2005 JP 2005263859
(71) Applicant: Idemitsu Kosan Co., Ltd., Chiyoda-ku Tokyo 100-8321 (JP)
(72) Inventor: TOMAI, Shigekazu, Chiba, 299-0293 (JP); INOUE, Kazuyoshi, Chiba, 299-0293 (JP); MATSUZAKI, Shigeo, Chiba, 299-0293 (JP)
(74) Representative: Gille Hrabal Struck Neidlein Prop Roos
(86) International application number: PCT/JP2006/316052
(87) International publication number: WO 2007/032175

(57) **Abstract**

A conductive multilayer stack (10) which includes: a first layer (12) formed of a metal or transparent conductive material, and a second layer (14) provided on the first layer (12), which is formed of an oxide, carbide or nitride of at least one metal selected from the group consisting of indium, tin, zinc, aluminum, magnesium, silicon, titanium, vanadium, manganese, cobalt, nickel, copper, gallium, germanium, yttrium, zirconia, niobium, molybdenum, antimony, barium, hafnium, tantalum, tungsten, bismuth, lanthanum, cerium, praseodymium, neodymium, samarium, europium, gadolinium, terbium, dysprosium, holmium, erbium, thulium and ytterbium, or carbon, wherein the second layer (14) has a work function larger than that of the first layer (12), and the second layer (14) had a film thickness of at least 0.5 nm and smaller than 50 nm.

## Description

### Field of the Invention

The invention relates to a conductive multilayer stack and an organic electroluminescence device (organic EL device) using the same.

### Background Art

The biggest challenges for realizing an organic EL display in large size is to improve luminous efficiency and to extend the operating lifetime. Of these, for the improvement of luminous efficiency, a method is proposed that hole injection efficiency is increased, for instance, by increasing the work function of an anode material to reduce the driving voltage. It is because many hole-transporting materials, as represented by TPD (triphenyldiamine), have such a large ionization potential as 5.6 eV, while ITO (indium tin oxide) generally used as a hole-injecting electrode has a work function of 4.6 to 5.0 eV. Therefore, an energy barrier of 0.6 to 1.0 eV exists when holes are injected from ITO to TPD.

As a means to increase the work function of ITO, a method to make the surface of ITO to be oxygen rich is proposed. For instance, Patent Document 1 discloses a method that after forming an ITO film at room temperature, the ITO film is heated or subjected to oxygen plasma exposure in an oxidizing atmosphere, Patent Document 2 a method in which composition of sputtering atmosphere gas is made oxygen rich at the surface side of ITO, and Patent Document 3 a method in which oxygen ion implantation is carried out after forming an ITO film.

On the other hand, as for methods of extending the operating lifetime, it has been reported so far that the purity of an emitting material is increased, a material having a high glass-transition temperature is selected, or the like. Further, Patent Documents 4, 5, 6, 7, and 8 disclose approaches from electrode materials. The organic EL devices disclosed in these documents have a structure in which an inorganic semiconductor layer as a hole-injecting layer or an electron-injecting layer and an organic emitting layer are stacked. By using the inorganic semiconductor layer which deteriorates less than the organic layer, the operating life time of the device is improved. In Patent Document 4, various materials are used for the inorganic semiconductor layer, for instance, noncrystalline materials of III-V group or II-V group represented by amorphous Si₁₋ₓCₓ, or crystalline materials such as CuI, CuS, GaAs, and ZnTe. Further, Patent Document 6 and Patent Document 7 disclose an example using crystalline oxide semiconductor materials such as Cu₂O as the material for the inorganic semiconductor layer. Furthermore, Patent Document 8 discloses a method in which an inorganic non-degenerated semiconductor layer which contains an amorphous material or micro crystalline material and has a larger band gap energy than that of the organic emitting layer is provided between an anode and the organic emitting layer.

However, in the organic EL devices disclosed in Patent Documents 4 and 5, when a crystalline material such as CuI is used, a polycrystalline inorganic semiconductor layer is generally formed. The surface of the polycrystalline inorganic semiconductor layer is inferior in flatness and has an asperity of about 50 nm or more. Therefore, when a thin film of an organic emitting layer is formed thereon, convexes on the surface of the inorganic semiconductor layer may penetrate the thin film. In such a case, the inorganic semiconductor layer and the electrode on the organic emitting layer are shorted to generate a leak current. Alternatively, even if not being shorted, an electric field concentrates on convexes whereby a leak current is apt to generate. Hence these organic EL devices have a problem of lowered luminous efficiency. Further, when the inorganic semiconductor layer is formed, a higher temperature (200°C or more) than the heat resisting temperature of the organic emitting layer is needed. Therefore, the organic emitting layer has to be formed after formation of the inorganic semiconductor layer.

The amorphous material represented by Si₁₋ₓCₓ used in the organic EL devices disclosed in Patent Documents 4 and 5 has an energy gap smaller than 2.6 eV. On the contrary, an organic emitting layer containing an aluminum complex or a stilbene derivative has an energy gap larger than 2.6 eV. As a result, the excitation state tends to be deactived by energy transfer to the inorganic semiconductor layer. Thus, there is the problem that the luminous efficiency of the organic EL device deteriorates.

The oxide semiconductor such as Cu₂O, used in Patent Documents 6 and 7, is a crystalline substance. The oxide semiconductor such as Cu₂O is fired at a high temperature to usually become polycrystalline in the case where the film thickness is 50 nm or more. In this case, there is also a problem that a leak current generates due to the asperity on the surface, thereby reducing the luminous efficiency, like Patent Documents 4 and 5.

Patent Document 8 discloses an organic EL device which has a structure in which a first electrode layer, an inorganic non-degenerated semiconductor layer, at least one organic layer including an emitting layer, and a second electrode layer are stacked in sequence, wherein the inorganic non-degenerated semiconductor layer contains an amorphous material or micro crystalline material, and has a band gap energy larger than that of the organic emitting layer, and describes that the efficiency of the device can be improved and the operating lifetime thereof can be extended.

However, the method of Patent Document 8 restricts the contact interface between the emitting layer made of an organic substance and the semiconductor layer made of an inorganic substance only by the magnitude relation of the energy levels thereof and therefore it has a defect that injection is not always promoted depending upon the adhesion therebetween.
[Patent Document 1] JP-A-H08-167479
[Patent Document 2] JP-A-2000-68073
[Patent Document 3] JP-A-2001-284060
[Patent Document 4] JP-A-H01-312873
[Patent Document 5] JP-A-H02-207488
[Patent Document 6] JP-A-H05-41285
[Patent Document 7] JP-A-H06-119973
[Patent Document 8] JP-A-H11-297478

An object of the invention is to provide an organic EL device driven with low voltage, and having a high luminous efficiency and a long operating lifetime.

### Disclosure of Invention

The inventors have ardently studied to solve the above-mentioned problems, and as a result, found that an organic EL device which satisfies low driving voltage, the improvement of luminous efficiency and the extension of operating lifetime at the same time can be obtained by using a conductive multilayer stack of a particular first layer, and a second layer as an anode.
According to the invention, the following conductive multilayer stack and organic EL device are provided.
1. A conductive multilayer stack which comprises:
   a first layer formed of a metal or transparent conductive material, and
   a second layer provided on the first layer, which is formed of an oxide, carbide or nitride of at least one metal selected from the group consisting of indium, tin, zinc, aluminum, magnesium, silicon, titanium, vanadium, manganese, cobalt, nickel, copper, gallium, germanium, yttrium, zirconia, niobium, molybdenum, antimony, barium, hafnium, tantalum, tungsten, bismuth, lanthanum, cerium, praseodymium, neodymium, samarium, europium, gadolinium, terbium, dysprosium, holmium, erbium, thulium and ytterbium, or carbon,
   wherein the second layer has a work function larger than that of the first layer, and
   the second layer has a film thickness of at least 0.5 nm and smaller than 50 nm.
2. The conductive multilayer stack according to 1 above, wherein the second layer has a film thickness of at least 1 nm and not larger than 20 nm.
3. The conductive multilayer stack according to 1 or 2 above, wherein the second layer has a carrier concentration of 10¹⁵ cm⁻³ or higher.
4. The conductive multilayer stack according to any one of 1 to 3 above, wherein the first layer is formed of at least one metal selected from the group consisting of gold, platinum, palladium, copper, aluminum, neodymium, silicon, titanium, chromium, nickel, silver and molybdenum.
5. The conductive multilayer stack according to any one of 1 to 3 above, wherein the transparent conductive material which constitutes the first layer is an oxide of at least one metal selected from the group consisting of indium, zinc, tin, aluminum, gallium, titanium and niobium.
6. The conductive multilayer stack according to any one of 1 to 5 above, wherein the second layer is formed of an oxide of at least one metal selected from the group consisting of indium, tin, zinc, lanthanum, cerium, praseodymium, neodymium, samarium, europium, gadolinium, terbium, dysprosium, holmium, erbium, thulium and ytterbium.
7. An organic electroluminescence device comprising:
   a cathode;
   an anode using the conductive multilayer stack according to any one of 1 to 6 above; and
   an organic layer containing an emitting layer between the cathode and the anode.

According to the invention, an organic EL device driven with low voltage, having a high luminous efficiency and long operating lifetime can be provided.

### Brief Description of Drawings

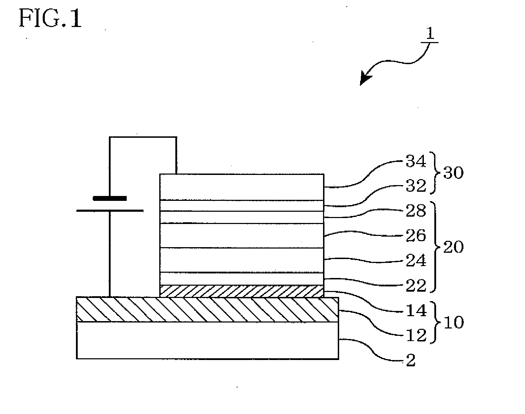

Fig. 1 is a view showing an embodiment of the organic EL device of the invention.

### Best Mode for Carrying out the Invention

The conductive multilayer stack of the invention comprises the first layer and the second layer.
The first layer is formed of a metal or a transparent conductive material.
In the case where the conductive multilayer stack is used as an electrode or the like, unless transparency is required, the first layer is preferably formed of at least one metal selected from the group consisting of gold, platinum, palladium, copper, aluminum, neodymium, silicon, titanium, chromium, nickel, zinc, molybdenum, indium, tin, silver and antimony. More preferred is at least one metal selected from the group consisting of gold, platinum, palladium, copper, aluminum, neodymium, silicon, titanium, chromium, nickel, silver and molybdenum.
The film thickness of the first layer is not particularly limited, for example, 10 nm to 500 nm. Meanwhile in the case where transparency is required because an emission is outcoupled through the electrode, or the like, at least a translucent electrode can be obtained by making the metal film thickness to be at least 5 nm and smaller than 50 nm.

If more transparency is required, the first layer is preferably formed of an oxide of at least one metal selected from the group consisting of indium, zinc, tin, aluminum, gallium, titanium and niobium, which is a transparent conductive material. Examples of the transparent conductive material include an oxide of indium and tin, an oxide of indium, tin and zinc, an oxide of zinc and aluminum, an oxide of zinc,and gallium, oxide of titanium and niobium, and an oxide of indium and zinc.

The second layer is formed of an oxide, a carbide or a nitride of at least one metal selected from the group consisting of indium, tin, zinc, aluminum, magnesium, silicon, titanium, vanadium, manganese, cobalt, nickel, copper, gallium, germanium, yttrium, zirconia, niobium, molybdenum, antimony, barium, hafnium, tantalum, tungsten, bismuth, lanthanum, cerium, praseodymium, neodymium, samarium, europium, gadolinium, terbium, dysprosium, holmium, erbium, thulium and ytterbium, or carbon.
When the second layer is formed of an oxide of at least one metal selected from the group consisting of indium, tin, zinc, aluminum, lanthanum, cerium, praseodymium, neodymium, samarium, europium, gadolinium, terbium, dysprosium, holmium, erbium, thulium and ytterbium, decrease of the driving voltage, improvement of the luminous efficiency and extension of the operating lifetime of the organic EL device can be attained more effectively.
Further, for the material constituting the second layer, conductive carbon, a carbide such as SiC or TiC, and a nitride such as TiN can be used as the material which effectively injects holes, if these substances have a work function larger than that of the material constituting the first layer.

The second layer preferably has a film thickness of at least 0.5 nm and smaller than 50 nm. When the second layer has a film thickness smaller than 0.5 nm, the film thickness is so small that no electric field may be generated. Also, when the second layer has a film thickness of 50 nm or larger, the film thickness is so large that an electric field for promoting injection of holes may not effectively act. More preferably the film thickness is at least 1 nm and not larger than 20 nm.

In the multilayer stack of the invention, the second layer has a work function larger than that of the first layer.
When the second layer has a work function larger than that of the first layer, electrons diffuse from the first layer to the second layer so that their Fermi levels become equal at the time of stacking these two layers. Hereby, an electric field is generated in the direction where positive injection of holes is facilitated.

The second layer preferably has a carrier concentration of 10¹⁵ cm⁻³ or higher. When the carrier concentration is lower than 10¹⁵ cm⁻³, the second layer may not accept electrons at the time of joining with the first layer, whereby the electric field for promoting injection of holes may not be generated.

When the conductive multilayer stack of the invention is used as an electrode, the multilayer stack is generally fabricated by forming the first layer on an insulative substrate so that the first layer resides on the substrate side.

The conductive multilayer stack of the invention can be fabricated by a method such as sputtering, ion plating, vacuum deposition, sol-gel or printing to sequentially stack the two layers in order.

The conductive multilayer stack of the invention can be used as an electrode, particularly an organic EL electrode for promoting injection of holes.

The organic EL device of the invention uses the above-mentioned conductive multilayer stack for the anode.
Fig. 1 shows one embodiment of the organic EL device of the invention.
As shown in the figure, an organic EL device 1 is formed on a glass substrate 2, and the organic EL device 1 has an organic layer 20 in between opposite anode 10 and cathode 30.
The anode 10 is constituted by the conductive multilayer stack of the invention, which is a multilayer stack composed of the first layer 12 and the second layer 14.
The organic layer 20 is composed of a hole-injecting layer 22, a hole-transporting layer 24, an emitting layer 26, and an electron-injecting layer 28. Holes supplied from the hole-transporting layer 24 and electrons supplied from the electron-injecting layer 28 are combined in the emitting layer 26, to emit light.
The cathode 30 is a multilayer stack composed of a conductive layer 32 and an electron injecting metal layer 34.
It is noted that the construction of the organic EL device is not limited to that shown in Fig. 1, and various modifications can be applied.

### [EXAMPLES]

### [Example 1]

### (1) Production of Target 1

Two hundred and sixty grams of indium oxide powder (average particle diameter 1 µm) having a purity of 99.99%, and 40 grams of tin oxide powder (average particle diameter 1 µm) having a purity of 99.99% were charged in a pot made of polyimide together with ethanol and alumina balls, and mixed by a planetary ball mill for 2 hours. The resultant powder mixture was fed in a die, and subjected to preliminary molding using a die press molding machine at a pressure of 100 kg/cm². Subsequently, the preliminary molded powder mixture was consolidated by a cold isostatic press molding machine at a pressure of 4 t/cm², followed by sintering in a sintering furnace under an air atmosphere at a temperature of 1300°C for 4 hours. The chemical composition of the sintered body was analyzed by ICP analysis, and the ratio of metal atoms (In:Sn) was 83:17. The sintered body had a density of 95%.

### (2) Production of Target 2

Two hundred and sixty grams of indium oxide powder (average particle diameter of 1 µm) having a purity of 99.99%, and 40 grams of zinc oxide powder (average particle diameter of 1 µm) having a purity of 99.99% were charged in a pot made of polyimide together with ethanol and alumina balls, and mixed by a planetary ball mill for 2 hours. The resultant powder mixture was fed to a die, and subjected to preliminary molding by a die press molding machine at a pressure of 100 kg/cm². Subsequently, the preliminary molded powder mixture was consolidated by a cold isostatic press molding machine at a pressure of 4 t/cm², followed by sintering in a sintering furnace under an air atmosphere at a temperature of 1300°C for 4 hours. The chemical composition of the resultant sintered body was analyzed by ICP analysis to find a ratio of the metal atoms (In:Zn) being 85:15. The sintered body had a density of 95%.

### (3) Formation of Electrode film

The target 1 produced in (1) above was loaded in a sputtering equipment, after deaerating to 2×10⁻⁴ Pa, a film was formed on a glass under the conditions that a sputtering pressure was 0.1 Pa, a ratio of argon:oxygen was 98:2, a sputtering power was 0.1 W/cm² and a sputtering time was 5 minutes. The resultant conductive film had a film thickness of 120 nm and a specific resistance of 2×10⁻³ Ω·cm. Subsequently, the conductive film was annealed in an air at a temperature of 300°C for 1 hour to obtain a transparent electrode of ITO (ITO substrate). The work function of ITO thus obtained was determined by AC-1 (Riken Keiki Co., Ltd.) to find it being 4.8 eV. Also, the ITO glass was cut into a square of 1 cm on a side, a silver paste was applied at the four corners thereof, and Hall effect was determined by an apparatus manufactured by Toyo Corporation (RESITEST8300). As a result, the carrier concentration was 9×10²¹ cm⁻³.
The target 2 produced in (2) above was loaded into a sputtering apparatus, after deaeration to 2×10⁻⁴ Pa, a film was formed on a substrate under the conditions that sputtering pressure was 0.1 Pa, a ratio of argon:oxygen was 98:2, a sputtering power was 0.1 W/cm² and sputtering time was 5 seconds to obtain IZO (indium zinc oxide). As the substrate on which a film was formed, both the ITO substrate obtained above and a glass slide were used. For determination of the properties of IZO alone, the film formed on the glass slide was used, and the same evaluation as ITO was carried out. As a result, the film thickness was 2 nm, the specific resistance was 2×10⁻² Ω·cm, the work function was 5.3 eV and the carrier concentration was 5×10¹⁹ cm⁻³. Here, the film thickness was controlled by the time period of forming a film based on a calibration curve. The calibration curve had been made from the film thickness determined by DEKTAK (manufactured by SLOAN) in the case where a film was formed by using the target 2 for 5 minutes under the same conditions.

### (4) Fabrication of EL Device

An 8-hydroxyquinoline A1 complex (Alq complex) of an electron-transporting organic compound was deposited on the ITO (120 nm)/IZO (2nm) multilayer stack obtained in (3) above to form a film having a thickness of 60 nm by resistance heating as an emitting layer. Further, an Al:Li alloy was deposited on the emitting layer by resistance heating to form a film having a thickness of 200 nm as a counter electrode. In Example 1, this counter electrode acted as the cathode. The organic EL device was fabricated through the above steps.

### (5) Performance Measurement of EL Device

The device was driven with a constant voltage by impressing a voltage of 6 V in between the bottom electrode and the counter electrode. At this time, the initial luminance was 120 cd/m² and the luminous efficiency was 1.5 lm/W. The half lifetime was determined under a constant electric current of 120 cd/m², and was found to be 5700 hours. Here, the half lifetime means a period of time required for the luminance to decrease to a half value of the initial value.

These performances of the organic EL device were totally evaluated on the basis of the criteria described below, and indicated in Table 1.
⊚: A device satisfies all of the following performances:
   Initial luminance: at least 200 cd/m²,
   Efficiency: 1.5 lm/W, and
   Half lifetime: at least 5000 hours.
○: A device satisfies all of the following performances:
   Initial luminance: at least 100 cd/m²,
   Efficiency: 1.2 lm/W, and
   Half lifetime: at least 2000 hours.
Δ: A device satisfies all of the following performances:
   Initial luminance: at least 50 cd/m²,
   Efficiency: 1.0 lm/W, and
   Half lifetime: at least 1000 hours
×: A device does not satisfy any one or all of the following performances:
   Initial luminance: at least 50 cd/m²,
   Efficiency: 1.0 1m/W, and
   Half lifetime: at least 1000 hours.

### [Examples 2 to 27, and Comparative Examples 1 to 3]

Targets were produced in the same manner as in Example 1 except that the materials for the targets 1 and 2 were changed to oxide powders of metal elements indicated in Tables 1 and 2. Subsequently, multilayer stacks and organic EL devices were fabricated in the same manner as in Example 1, and the performances of the resultant organic EL devices were evaluated. The results are shown in Tables 1 and 2.
Here, the composition of the target indicates a ratio of each metal atom relative to the total amount of the metal atoms, and the target contains an oxygen atom other than the metal atoms.

### [Examples 28 to 36]

In Examples 28 to 36, metal films were used as the first layer. As the target 1, targets composed of metals or alloys indicated in Table 2 were used. As the target 2, targets were produced in the same manner as in Example 1, except that oxide powders of metal elements indicated in Table 2 were used.
Multilayer stacks and organic EL devices were fabricated in the same manner as in Example 1, except that sputtering was carried out by using these targets without introduction of oxygen, and the performances of the resultant organic EL devices were evaluated. The results are shown in Table 2.

Table 1

**Table 1**

| | Sputtering Terget 1 Composition (at%) | Sputtering Terget 2 Composition (at%) | 1st Layer Thickness (nm) | 2nd Layer Thickness (nm) | 1st Layer Work Function (eV) | 2nd Layer Work Function (eV) | 2nd Layer Carrier Concentration (cm⁻³) | Initial Luminance (cd/m²) | Luminous Efficiency (lm/W) | Half Lifetime (hours) | Evaluation |
|---|---|---|---|---|---|---|---|---|---|---|---|
| Ex. 1 | In:Sn=83:17 | In:Zn=85:15 | 120 | 2 | 4.8 | 5.3 | 5×10¹⁹ | 150 | 1.5 | 5700 | ○ |
| Ex. 2 | In:Sn:Zn=72:16:12 | In:Sn=83:17 | 120 | 10 | 4.9 | 5.1 | 7×10¹⁹ | 140 | 1.4 | 5200 | ○ |
| Ex. 3 | In:Sn=83:17 | Zn:Al=95:5 | 120 | 20 | 4.8 | 5 | 1×10¹⁵ | 140 | 1.5 | 5500 | ○ |
| Ex. 4 | In:Sn=83:17 | In:Mg=90:10 | 120 | 20 | 4.8 | 5.1 | 1×10¹⁹ | 200 | 1.9 | 9800 | ⊚ |
| Ex. 5 | In:Sn=83:17 | In:Si=90:10 | 120 | 5 | 4.8 | 5.3 | 6×10¹⁸ | 140 | 1.3 | 4600 | ○ |
| Ex. 6 | In:Sn=83:17 | In:Ti=90:10 | 120 | 1 | 4.8 | 5.2 | 3×10¹⁸ | 150 | 1.6 | 4400 | ○ |
| Ex. 7 | In:Sn=83:17 | In:V=90:10 | 120 | 49 | 4.8 | 5.3 | 1×10¹⁸ | 150 | 1.8 | 5000 | ○ |
| Ex. 8 | In:Sn=83:17 | In:Mn=90:10 | 120 | 0.5 | 4.8 | 5.2 | 3×10¹⁸ | 150 | 1.6 | 4800 | ○ |
| Ex. 9 | In:Sn=83:17 | In:Co=90:10 | 120 | 30 | 4.8 | 5.3 | 2×10¹⁸ | 150 | 1.4 | 3900 | ○ |
| Ex. 10 | In:Sn=83:17 | In:Ni=90:10 | 120 | 30 | 4.8 | 5.4 | 2×10¹⁸ | 130 | 1.2 | 3800 | ○ |
| Ex. 11 | In:Sn=83:17 | In:Cu=90:10 | 120 | 0.5 | 4.8 | 5.3 | 4×10¹⁸ | 120 | 1.2 | 2900 | ○ |
| Ex. 12 | In:Sn:Zn=72:16:12 | In:Ga=90:10 | 120 | 49 | 4.9 | 5.2 | 2×10¹⁸ | 90 | 1 | 2500 | Δ |
| Ex. 13 | In:Sn:Zn=72:16:12 | In:Ge=90:10 | 120 | 10 | 4.9 | 5.2 | 2×10¹⁸ | 130 | 1.3 | 3500 | ○ |
| Ex. 14 | In:Sn:Zn=72:16:12 | In:Y=90:10 | 120 | 10 | 4.9 | 5.1 | 4×10¹⁷ | 150 | 1.3 | 3500 | ○ |
| Ex. 15 | In:Sn:Zn=72:16:12 | In:Zr=90:10 | 120 | 5 | 4.9 | 5.2 | 5x10¹⁸ | 95 | 1 | 2500 | Δ |
| Ex. 16 | In:Sn:Zn=72:16:12 | In:Nb=90:10 | 120 | 5 | 4.9 | 5.2 | 5×10¹⁸ | 80 | 1 | 2400 | Δ |
| Ex. 17 | Zn:Al=95:5 | In:Mo=90:10 | 120 | 20 | 4.6 | 5.2 | 3×10¹⁸ | 210 | 1.9 | 7800 | ⊚ |
| Ex. 18 | Zn:Ga=95:5 | In:Sb=90:10 | 120 | 10 | 4.6 | 5.3 | 2×10¹⁸ | 220 | 1.9 | 6800 | ⊚ |
| Ex. 19 | Ti:Nb=95:5 | In:Ba=90:10 | 120 | 5 | 5.2 | 5.3 | 2×10¹⁸ | 80 | 1 | 3500 | Δ |
| Ex. 20 | In:Zn=85:15 | In:Hf=90:10 | 120 | 5 | 4.9 | 5.2 | 3×10¹⁸ | 90 | 1 | 3600 | Δ |

Table 2

**Table 2**

| | Sputtering Target 1 Composition (at%) | Sputtering Target 2 Composition (at%) | 1st Layer Thickness (nm) | 2nd Layer Thickness (nm) | 1st Layer Work Function (eV) | 2nd Layer Work Function (eV) | 2nd Layer Carrier Concentration (cm⁻³) | Initial Luminance (cd/m2) | Luminous Efficiency (1m/W) | Half Lifetime (hours) | Evaluation |
|---|---|---|---|---|---|---|---|---|---|---|---|
| Ex. 24 | In:Zn=85:15 | In:La=90:10 | 120 | 20 | 4.9 | 5.3 | 3×10¹⁹ | 170 | 1.7 | 7100 | ○ |
| Ex. 25 | In:Zn=85:15 | In:Sn:Ce=90:5:5 | 120 | 10 | 4.9 | 5.5 | 2×10¹⁹ | 200 | 2.1 | 8100 | ⊚ |
| Ex. 26 | In:Zn=85:15 | In:Zn:PX=90:5:5 | 120 | 10 | 4.9 | 5.3 | 1×10¹⁹ | 210 | 2.2 | 8000 | ⊚ |
| Ex. 27 | In:Sn:=83:17 | In:Sn:Nd=90:5.5 | 120 | 10 | 4.8 | 5.5 | 9×10¹⁸ | 220 | 2.2 | 9500 | ⊚ |
| Ex. 28 | Mo(Metal) | Tn:Sn:Sm=90:5:5 | 10 | 20 | 4.6 | 5.5 | 9×10¹⁸ | 150 | 1.9 | 7500 | ○ |
| Ex. 29 | Ni(Metal) | In:Eu=90:10 | 10 | 20 | 5.2 | 5.3 | 3×10¹⁸ | 90 | 1.2 | 3200 | Δ |
| Ex. 30 | Au(Metal) | In:Gd=90:10 | 10 | 20 | 5.1 | 5.3 | 2×10¹⁸ | 60 | 1.3 | 2500 | Δ |
| Ex. 31 | Pt(Metal) | In:Tb=90:10 | 10 | 10 | 5.4 | 5.5 | 2×10¹⁸ | 70 | 1.2 | 2500 | Δ |
| Ex. 32 | Pd(Metal) | In:Dy=90:10 | 10 | 10 | 5.4 | 5.5 | 2×10¹⁸ | 80 | 1.3 | 3100 | Δ |
| Ex. 33 | Cu(Metal) | In:Ho=90:10 | 10 | 10 | 4.8 | 5.2 | 3×10¹⁸ | 120 | 1.5 | 5500 | ○ |
| Ex. 34 | Ag-Pd-Cu(Metal) | In:Er=90:10 | 10 | 20 | 4.4 | 5.2 | 2×10¹⁸ | 120 | 1.5 | 5200 | ○ |
| Ex. 35 | Al-Si(Metal) | In:Tm=90:10 | 10 | 20 | 4.3 | 5.2 | 2×10¹⁸ | 130 | 1.5 | 5200 | ○ |
| Ex. 36 | Cr(Metal) | In:Yb=90:10 | 10 | 20 | 4.5 | 5.2 | 3×10¹⁸ | 120 | 1.6 | 5300 | ○ |
| Comp. Ex. 1 | In:Sn=83:17 | Non | 120 | - | 4.8 | - | - | 40 | 0.8 | 2500 | × |
| Comp. Ex. 2 | In:Sn=83:17 | In:Mg=90:10 | 120 | 100 | 4.8 | 5.1 | 1×10¹⁹ | 30 | 0.7 | 2600 | × |
| Comp. Ex. 3 | In:W=83:17 | In:Sn=90:10 | 120 | 100 | 5.2 | 5.1 | 1×10¹⁹ | 50 | 0.8 | 1300 | × |

### Industrial Applicability

The conductive multilayer stack of the invention can be used as an electrode. In particular, it can suitably be used for devices such as organic EL devices necessary to control the injection of carriers.
The organic EL device of the invention can be used for various types of displays.

## Claims

1. A conductive multilayer stack which comprises:
a first layer formed of a metal or a transparent conductive material, and
a second layer provided on the first layer, which is formed of an oxide, a carbide or a nitride of at least one metal selected from the group consisting of indium, tin, zinc, aluminum, magnesium, silicon, titanium, vanadium, manganese, cobalt, nickel, copper, gallium, germanium, yttrium, zirconia, niobium, molybdenum, antimony, barium, hafnium, tantalum, tungsten, bismuth, lanthanum, cerium, praseodymium, neodymium, samarium, europium, gadolinium, terbium, dysprosium, holmium, erbium, thulium and ytterbium, or carbon,
wherein the second layer has a work function larger than that of the first layer, and
the second layer has a film thickness of at least 0.5 nm and smaller than 50 nm.

2. The conductive multilayer stack according to claim 1, wherein the second layer has a film thickness of at least 1 nm and not larger than 20 nm.

3. The conductive multilayer stack according to claim 1 or 2, wherein the second layer has a carrier concentration of 10¹⁵ cm⁻³ or higher.

4. The conductive multilayer stack according to any one of claims 1 to 3, wherein the first layer is formed of at least one metal selected from the group consisting of gold, platinum, palladium, copper, aluminum, neodymium, silicon, titanium, chromium, nickel, silver and molybdenum.

5. The conductive multilayer stack according to any one of claims 1 to 3, wherein the transparent conductive material which constitutes the first layer is an oxide of at least one metal selected from the group consisting of indium, zinc, tin, aluminum, gallium, titanium and niobium.

6. The conductive multilayer stack according to any one of claims 1 to 5, wherein the second layer is formed of an oxide of at least one metal selected from the group consisting of indium, tin, zinc, lanthanum, cerium, praseodymium, neodymium, samarium, europium, gadolinium, terbium, dysprosium, holmium, erbium, thulium and ytterbium.

7. An organic electroluminescence device comprising:
a cathode;
an anode using the conductive multilayer stack according to any one of claims 1 to 6; and
an organic layer containing an emitting layer between the cathode and the anode.
